# EUROPÄISCHE PATENTSCHRIFT

(11) **EP 0 620 499 B1**
(45) Veröffentlichungstag und Bekanntmachung des Hinweises auf die Patenterteilung: **26.02.1997**
(21) Anmeldenummer: 94105030.4
(22) Anmeldetag: 30.03.1994
(51) Int. Cl.: G03F 3/10, G03F 7/34

(54) **Photopolymerisierbares Material und Verfahren zur Herstellung eines farbigen Bildes**
Photopolymerisable material and process for making colour image
Matériau photopolymérisable et procédé pour réaliser une image en couleur

(30) Priorität: 10.04.1993 DE 4311949
(43) Veröffentlichungstag der Anmeldung: 19.10.1994
(73) Patentinhaber: Agfa-Gevaert AG, D-51373 Leverkusen (DE)
(72) Erfinder: Platzer, Stephan J.W., Dr., Califon, New Jersey 07830 (US); Buhr, Gerhard, Dr., D-61462 Königstein (DE); Michel, Manfred, Dr., D-65201 Wiesbaden (DE); Buchmann, Andrea, D-65203 Wiesbaden (DE)

(56) Entgegenhaltungen:
- EP-A- 0 514 186
- RESEARCH DISCLOSURE, Bd.222, Oktober 1982, HAVANT GB Seiten 328 - 329 D. D'HONDT ET AL 'Photodelamination Imaging'
- PHOTOGRAPHIC SCIENCE AND ENGINEERING, Bd.22, Nr.3, 1978, WASHINGTON US Seiten 138 - 141 T. NAKAYAMA ET AL. 'Photodelamination Imaging - A New Approach in Dry Processing'

## Beschreibung

Die Erfindung betrifft ein photopolymerisierbares Material, das zur Herstellung von farbigen Bildern, insbesondere zur Farbprüfung für den Mehrtarbendruck geeignet ist. Sie betrifft ferner ein Verfahren zur Herstellung eines farbigen Bildes, insbesondere ein Farbprüfverfahren, bei dem ein photopolymerisierbares Material aus einer transparenten Trägerfolie, einer farbigen polymerisierbaren Schicht und einer thermoplastischen Haftschicht auf ein Bildempfangsblatt laminiert, durch die Trägerfolie hindurch bildmäßig belichtet und durch Abziehen der Trägerfolie zusammen mit den belichteten Bereichen der farbigen polymerisierbaren Schicht zum Bild entwickelt wird.

Derartige Materialien und Verfahren sind bekannt und z.B. in den US-A 4 895 787 und 5 049 476 beschrieben. Das Verfahren hat den großen Vorteil, daß zur Entwicklung des Bildes keine alkalischen oder sauren Lösungen und keine organischen Lösemittel erforderlich sind. Diese Materialien bestehen aus einer transparenten Trägerfolie, einer farbigen photopolymerisierbaren Schicht und einer durch Wärme aktivierbaren Haftschicht. Ein Nachteil dieser Materialien besteht darin, daß sie Bilder liefern, deren Hintergrundbereiche nach Gelb verfärbt sind. Wie gefunden wurde, ist diese Verfärbung vorwiegend auf den in der photopolymerisierbaren Schicht enthaltenen Photoinitiator zurückzuführen, der bei der Lagerung in die Haftschicht diffundieren kann. Da dieser auch in den Bildstellen der photopolymerisierbaren Schicht enthalten ist, wird die Farbe jedes einzelnen Farbbildes durch seine Anwesenheit verfälscht. Man hat zwar versucht, Photoinitiatoren einzusetzen, deren Absorption ausschließlich im Ultraviolett liegt und die deshalb im sichtbaren Bereich farblos erscheinen. Diese Photoninitiatoren sind jedoch im Licht der üblichen Kopierlampen wesentlich weniger wirksam und erfordern sehr lange Belichtungszeiten. Auch wurde gefunden, daß selbst mit visuell farblosen Photoinitiatoren eine Farbverschiebung einsetzen kann, da diese Verbindungen häufig gefärbte Lichtzersetzungsprodukte liefern.

In der US-A 3 615 435 ist ein Verfahren zur Herstellung farbiger Bilder beschrieben, bei dem ein lichtempfindliches Material aus einem Schichtträger, einer ungefärbten photopolymerisierbaren Schicht, einer farbigen photopolymerisierbaren Schicht und einem Bildempfangsblatt bildmäßig belichtet und durch Auseinanderziehen zum Bild entwickelt wird. Dabei verbleiben die unbelichteten Bereiche der farbigen photopolymerisierbaren Schicht auf dem Bildempfangsblatt, während die belichteten Bereiche auf dem Schichtträger verbleiben. Auf diese Weise werden einfarbige Bilder erhalten. Es wird auch die Herstellung mehrfarbiger Bilder aus übereinanderliegenden Teilfarbenbildern beschrieben. Hierbei erfolgt jedoch stets die Entwicklung durch Auswaschen. Auch bei diesem Material tritt eine Farbverschiebung dadurch ein, daß die farbige photopolymerisierbare Schicht einen Photoinitiator enthält.

In der US-A 4 288 525 ist ein ähnliches lichtempfindliches Material beschrieben, das eine ungefärbte photopolymerisierbare Schicht und eine farbige nicht lichtempfindliche Schicht aufweist. Das Material wird belichtet und durch Auseinanderziehen entwickelt. Dabei verbleiben an den belichteten Stellen die photopolymerisierbare Schicht und mindestens ein Teil der farbigen Schicht auf dem Schichtträger, während an den unbelichteten Stellen beide Schichten auf dem Bildempfangsmaterial verbleiben. Auch hier wird deshalb eine Farbverfälschung durch den Photoinitiator der photopolymerisierbaren Schicht in dem farbigen positiven Bild bewirkt. Ein ähnliches Material und Verfahren ist in der US-A 4 692 395 beschrieben.

Aufgabe der Erfindung war es, ein photopolymerisierbares Material und ein Verfahren zur Herstellung von farbigen Bildern, insbesondere mehrfarbigen Bildern vorzuschlagen, das es erlaubt, farbreine Bilder zu erzeugen, die nicht durch Photoinitiatorreste, die im sichtbaren Spektralbereich absorbieren, verfälscht sind, das aber trotzdem die Nutzung von hochlichtempfindlichen photopolymerisierbaren Gemischen erlaubt.

Die Erfindung geht aus von einem photopolymerisierbaren Material mit
(A) einer flexiblen, transparenten Trägerfolie,
(B) einer farbigen, polymerisierbaren Schicht, die ein polymeres organisches Bindemittel, eine radikalisch polymerisierbare Verbindung mit mindestens einer endständigen ethylenisch ungesättigten Gruppe und einen Farbstoff oder ein Farbpigment enthält, und
(C) einer Haftschicht, die ein thermoplastisches Polymeres enthält und ein Tg von 25 bis 100 °C aufweist.

Das erfindungsgemäße Material ist dadurch gekennzeichnet, daß die Schicht (B) keinen Photoinitiator enthält, daß zwischen der Trägerfolie (A) und der farbigen polymerisierbaren Schicht (B) eine ungefärbte photopolymerisierbare Schicht (D) angeordnet ist, die ein polymeres organisches Bindemittel, eine radikalisch polymerisierbare Verbindung mit mindestens einer endständigen ethylenisch ungesättigten Gruppe und einen Photopolymerisationsinitiator enthält, und daß die Kohäsion der Schichten (B), (C) und (D) und die Haftung dieser Schichten untereinander und an der Trägerfolie (A) so eingestellt sind, daß die Haftung (a₂) der photopolymerisierbaren Schicht (D) an der farbigen polymerisierbaren Schicht (B) im unbelichteten Zustand kleiner ist als die Haftung (a₃) der farbigen Schicht (B) an der Haftschicht (C) und die Haftung (a₁) der photopolymerisierbaren Schicht (D) an der Trägerfolie (A) und als die Kohäsionen (c₁), (c₂) und (c₃) der Schichten (D), (B) und (C) und daß die Haftung (a₃') der farbigen Schicht (B) an der Haftschicht (C) im belichteten Zustand kleiner ist als die Haftung (a₁') der photopolymerisierten Schicht (D) an der Trägerfolie (A) und die Haftung (a₂') der photopolymerisierten Schicht (D) an der farbigen Schicht (B) und als die Kohäsionen (c₁'), (c₂') und (c₃') der Schichten (D), (B) und (C).

Erfindungsgemäß wird ferner ein Verfahren zur Herstellung eines farbigen Bildes vorgeschlagen, das dadurch gekennzeichnet ist, daß man ein photopolymerisierbares Material der vorstehend angegebenen Beschaffenheit mit seiner Haftschicht (C) unter Druck und bei erhöhter Temperatur auf ein Bildempfangsblatt (E) laminiert, das erhaltene Laminat durch die Trägerfolie (A) hindurch bildmäßig belichtet und die Trägerfolie zusammen mit der photopolymerisierbaren Schicht (D) und den belichteten Bereichen der farbigen polymerisierbaren Schicht (B) von dem Bildempfangsblatt abzieht, wobei die Haftung der Haftschicht (C) an dem Bildempfangsblatt (E) im unbelichteten Zustand (a₄) größer ist als die Haftung (a₂) der photopolymerisierbaren Schicht (D) an der farbigen Schicht (B) und im belichteten Zustand (a₄') größer ist als die Haftung (a₃') der farbigen polymerisierbaren Schicht (B) an der Haftschicht (C).

Das erfindungsgemäße Verfahren wird bevorzugt zur Herstellung eines Teilfarbenbildes mit einem Material durchgeführt, das eine farbige polymerisierbare Schicht (B) in einer Grundfarbe des Mehrfarbendruckes enthält und unter einem Farbauszug belichtet wird, der der gleichen Grundfarbe entspricht. Insbesondere können die beschriebenen Verfahrensschritte auf dem gleichen Bildempfangsblatt mit Materialien in den anderen Grundfarben wiederholt werden, wobei die Belichtung jeweils im Register mit dem ersten auf dem Empfangsblatt vorliegenden Teilfarbenbild erfolgt.

Es ist ein wesentliches Merkmal des erfindungsgemäßen Materials, daß die farbige Schicht (B) zwar eine polymerisierbare Verbindung, jedoch keinen Photoinitiator enthält. Auf diese Weise wird sichergestellt, daß kein Photoinitiator aus dieser Schicht in die unmittelbar benachbarte Haftschicht diffundieren kann. Auch enthalten die auf das Bildempfangsblatt übertragenen farbigen Bildelemente praktisch keine Anteile an Photoinitiator, die ihren Farbeindruck verfälschen könnten. Es ist ferner wesentlich, daß die Schicht (B) eine polymerisierbare Verbindung enthält, die mindestens im Grenzbereich zu der photopolymerisierbaren Schicht (D) bei der Belichtung durch den Kontakt mit der polymerisierenden Verbindung in dieser Schicht ebenfalls zur Polymerisation angeregt wird und dadurch die Haftung zwischen beiden Schichten erhöht. Es ist nicht genau bekannt, wie weit sich die Polymerisation in die farbige Schicht hinein fortsetzt; jedenfalls hat sie eine wesentliche Erhöhung der Haftung zwischen den Schichten (B) und (D) zur Folge.

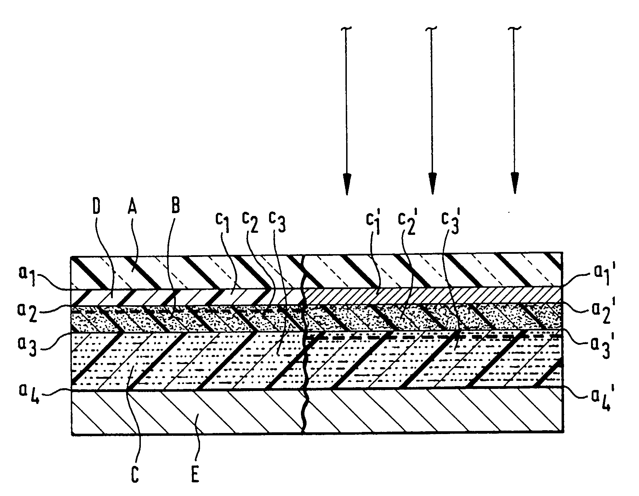

In der beiliegenden Zeichnung ist ein photopolymerisierbares Material gemäß der Erfindung nach dem Laminieren auf ein Bildempfangsmaterial (E) im Querschnitt dargestellt. Im rechten Teil der Figur wird, durch Pfeile angedeutet, das Material nach dem Belichten gezeigt, im linken Teil ein unbelichteter Bereich. Mit A und E sind die Trägerfolie und das Empfangsmaterial bezeichnet. Zwischen diesen sind die ungefärbte photopolymerisierbare Schicht (D), die farbige polymerisierbare Schicht (B) und die Haftschicht (C) angeordnet. Mit c₁ ist die Kohäsion der photopolymerisierbaren Schicht, mit c₂ die der farbigen polymerisierbaren Schicht und mit c₃ die der Haftschicht bezeichnet. Die Haftung an den verschiedenen Grenzflächen vor dem Belichten ist mit a₁, a₂, a₃ und a₄, die Haftung nach dem Belichten mit a₁', a₂', a₃' und a₄' im Sinne der obigen Erläuterungen angegeben. Durch die Schraffierung der Schicht (D) und der Grenzzone innerhalb der Schicht (B) ist im belichteten Teil die Wirkung der Polymerisation angedeutet.

Vor dem Belichten liegt die niedrigste Haftung (a₂) zwischen den Schichten (D) und (B) vor. Alle übrigen Haftungen sind ebenso wie alle Kohäsionen stärker als (a₂). Durch die Belichtung wird die Lage der geringsten Haftung verschoben, da wie vorstehend beschrieben, die Schichten (D) und (B) durch die Polymerisation fester aneinander verankert werden. Jetzt liegt die niedrigste Haftung (a₃') zwischen den Schichten (B) und (C) vor, die auch wieder geringer ist als jede der Kohäsionen c₁', c₂' und c₃'. Die gestrichelten Linien zeigen jeweils die Grenzlinie der geringsten Haftung, d.h. die Sollbruchstelle beim Auseinanderziehen von (A) und (E). Obwohl sich auch die Kohäsion der Schicht (D) und teilweise der Schicht (B) bei der Belichtung verändert, hat diese Veränderung auf die Lage der Sollbruchstelle keinen Einfluß.

Als ungefärbte photopolymerisierbare Schicht wird im Rahmen dieser Erfindung eine Schicht bezeichnet, die nicht durch Zusatz von im sichtbaren Spektralbereich absorbierenden Farbstoffen oder Farbpigmenten gefärbt ist. Wie bereits ausgeführt, ist die farbige polymerisierbare Schicht (B) selbst nicht lichtempfindlich; sie kann jedoch bei der Belichtung der benachbarten photopolymerisierbaren Schicht mindestens im Kontaktbereich zu dieser zur Polymerisation angeregt werden. Die Schicht kann ferner nach dem Übertragen der Bildstellen auf das Empfangsblatt durch eine intensive Belichtung ohne Vorlage, gegebenenfalls unter Erwärmen, nachgehärtet werden.

Als flexible transparente Trägerfolien (A) für das erfindungsgemäße Material sind insbesondere solche Kunststoffolien geeignet, die beim Erwärmen auf etwa 60 bis 130 °C maßbeständig sind. Hierfür kommen vorzugsweise Folien aus Polyestern, Polycarbonaten, Polyimiden und ähnlichen Polymeren in Betracht; Polyesterfolien werden im allgemeinen bevorzugt. Die Trägerfolie kann eine Dicke im Bereich von etwa 10 bis 120, vorzugsweise von 20 bis 80 µm aufweisen. Zur Verbesserung der Maßbeständigkeit werden die Folien im allgemeinen biaxial verstreckt und ggf. thermofixiert. Die Oberfläche der Folie kann glatt oder mattiert sein, glatte Folien werden zumeist bevorzugt. Zur Verbesserung der Haftung der photopolymerisierbaren Schicht (D) kann die Oberfläche einer die Haftung erhöhenden Behandlung unterworfen werden, z.B. durch Coronaentladung, durch Ätzen mit Chemikalien, z.B. Trichloressigsäure, und durch Beschichten mit einer haftvermittelnden Unterschicht. Derartige Beschichtungen sind im allgemeinen 0,001 bis 0,1 µm dick. Sie können aus Copolymeren von (Meth)acrylsäureestern bestehen, wie sie z.B. in der US-A 4 098 952 beschrieben sind, und vorzugsweise vernetzt sein. Geeignete Folien sind in der US-A 5 049 476 beschrieben.

Die photopolymerisierbare Schicht (D) enthält als wesentliche Bestandteile ein polymeres Bindemittel, eine polymerisierbare Verbindung, einen Photoinitiator sowie ggf. weitere übliche Zusätze. Als Bindemittel sind u.a. Homo- und Copolymere von (Meth)acrylsäureestern und besonders Polyvinylacetale, z.B. Polyvinylbutyral, -propional oder -formal geeignet. Der Mengenanteil des Bindemittels beträgt im allgemeinen 10 bis 75, vorzugsweise 30 bis 70 Gew.-%, bezogen auf die nichtflüchtigen Bestandteile der Schicht.

Die polymerisierbare Verbindung enthält mindestens eine, bevorzugt mindestens zwei endständige ethylenisch ungesättigte Gruppen. Besonders bevorzugt werden (Meth)acrylsäureester von mehrwertigen, insbesondere primären aliphatischen oder cycloaliphatischen Alkoholen. Die Verbindung sollte bei Normaldruck einen Siedepunkt von mindestens 100 °C haben. Beispiele für geeignete Verbindungen sind Acrylate und Methacrylate von Triethylenglykol, Tripropylenglykol, Tetraethylenglykol, 1,4-Butandiol, 1,6-Hexandiol, Trimethylolethan, Trimethylolpropan, Pentaerythrit, Dipentaervthrit und von mit Ethylenoxid oder Propylenoxid umgesetztem Bisphenol A oder Trimethylolpropan. Die polymerisierbare Verbindung ist in der Schicht im allgemeinen in einem Anteil von 10 bis 60, bevorzugt 15 bis 40 Gew.-%, bezogen auf die nichtflüchtigen Bestandteile, enthalten.
Der Photoinitiator ist eine durch Bestrahlung mit aktinischem Licht zur Bildung freier Radikale anregbare Verbindung. Beispiele sind Mehrkernchinone, Acyloine, insbesondere Benzoine, z.B. Benzoinalkylether, α-Alkyl-benzoine, Triarylimidazolyldimere, Chinoxalinverbindungen und besonders Trihalogenmethylverbindungen, insbesondere Trihalogenmethyl-s-triazine. Der Photoinitiator ist im allgemeinen in einer Menge von 2 bis 30, bevorzugt 5 bis 20 Gew.-% in der photopolymerisierbaren Schicht enthalten.

Als weitere Bestandteile kann die Schicht Inhibitoren für die thermische Polymerisation, spektrale Sensibilisatoren, Weichmacher, Oligomere, oberflächenaktive Verbindungen, inerte Füllstoffe, optische Aufheller, Lichthofschutzmittel, Photoaktivatoren, Wasserstoffdonatoren und Restlöser enthalten.

Die photopolymerisierbare Schicht hat im allgemeinen ein Schichtgewicht von 0,05 bis 3, bevorzugt von 0,2 bis 0,5 g/m².

Die farbige polymerisierbare Schicht (B) enthält ein polymeres Bindemittel, eine polymerisierbare Verbindung, einen Farbstoff oder ein Farbpigment und ggf. weitere übliche Zusätze. Die polymerisierbare Verbindung kann die gleiche sein wie die in der photopolymerisierbaren Schicht enthaltene. Sie kann auch eine andere aus der gleichen allgemeinen Gruppe ausgewahlte Verbindung sein und kann in gleichen Mengenanteilen vorliegen. Auch die weiteren Zusätze können die gleichen sein wie in der photopolymerisierbaren Schicht.

Als polymere Bindemittel kommen die gleichen in Betracht wie in der photopolymerisierbaren Schicht und zusätzlich Styrol/Maleinsäureanhydrid-, Styrol/Maleinsäurehalbester-Copolymere, Polyamide, Polyvinylpyrrolidone, Cellulosederivate wie Celluloseester und -ether, Phenolharze und Polyvinylester. Polyvinylacetale werden auch hier bevorzugt. Das Bindemittel ist allgemein in einer Menge von 10 bis 75, bevorzugt 20 bis 50 Gew.-%, bezogen auf die nichtflüchtigen Anteile der Schicht, enthalten.

Der Farbstoff oder das Farbpigment kann z.B. Permanentgelb G (C.I. 21 095), Permanentgelb GR (C.I. 21 100), Permanentgelb DHG (C.I. 21 090), Permanentrubin L6B (C.I. 15 850 : 1), Permanent Pink F3B (C.I. 12 433), Hostaperm Pink E (C.I. 73 915), Hostaperm Rotviolett ER (C.I. 46 500), Permanentkarmin FBB (C.I. 12 485), Hostapermblau B2G (C.I. 74 160), Hostapermblau A2R (C.I. 74 160) und Printex 25 (Ruß). Die Pigmente und Farbstoffe können ggf. zur Erzielung des gewünschten Farbtons abgemischt werden. Die Pigmente werden im allgemeinen zusammen mit einem Teil des Bindemittels in einem geeigneten Lösemittel dispergiert und angeteigt. Die mittlere Partikelgröße liegt i.a. unterhalb 1 µm, bevorzugt unterhalb 0,2 µm. Pigmente werden im allgemeinen gegenüber Farbstoffen bevorzugt. Der Farbstoff bzw. das Farbpigment ist in der Schicht gewöhnlich in einer Menge von 10 bis 50, bevorzugt 15 bis 35 Gew.-%, bezogen auf die nichtflüchtigen Bestandteile enthalten.

Die farbige polymerisierbare Schicht (B) hat im allgemeinen ein Schichtgewicht von 0,1 bis 5, vorzugsweise von 0,3 bis 1 g/m². Sie wird im allgemeinen durch Beschichten und Trocknen unter Verwendung von Lösemitteln hergestellt. Wenn die Lösemittel keine oder nur geringe Lösewirkung gegenüber den Bestandteilen der photopolymerisierbaren Schicht (D) haben, kann die Beschichtung unmittelbar auf diese Schicht aufgebracht werden. Anderenfalls kann die farbige polymerisierbare Schicht aus einer Lösung auf einen temporären Schichtträger aufgebracht, getrocknet und durch Laminieren auf die photopolymerisierbare Schicht übertragen werden.

Die Haftschicht (C) enthält ein thermoplastisches Polymeres und ggf. weitere Bestandteile. Sie hat die Eigenschaft, bei Erwärmen auf eine Temperatur im Bereich von 60 bis 130 °C klebrig zu werden. Sie wird aus Lösung oder Dispersion oder durch Laminieren auf die farbige polymerisierbare Schicht (B) aufgebracht. Geeignete Lösemittel, die die Schicht (B) nicht anlösen, sind gesättigte Kohlenwasserstoffe, z.B. Cyclohexan, n-Hexan und n-Heptan; Wasser oder Gemische von Wasser mit mischbaren organischen Lösemitteln. (Meth)acrylsäurecopolymere mit hoher Säurezahl oder Vinylacetat/Crotonsäure-Copolymere lassen sich aus wäßrigen, z.B. wäßrig-ammoniakalischen Lösungen aufbringen. Andere Polymere können aus wäßrigen Dispersionen aufgebracht werden, z.B. Vinylacetatpolymere. Wieder andere Polymere können aus der Schmelze aufgebracht werden, z.B. Ethylen/Vinylacetat-Copolymere. Die Haftschicht kann auch in der Weise auf die farbige polymerisierbare Schicht (B) aufgebracht werden, daß sie auf einem temporären Schichtträger hergestellt und von dort durch Laminieren und Abziehen des temporären Trägers auf die farbige polymerisierbare Schicht übertragen wird.

Die Haftschicht kann auch von dem temporären Träger auf das Bildempfangsblatt (E) durch Laminieren und Abziehen übertragen werden. Danach wird das photopolymerisierbare Material aus Trägerfolie (A), ungefärbter photopolymerisierbarer Schicht (D) und farbiger polymerisierbarer Schicht (B) mit der letzteren auf die auf dem Bildempfangsblatt befindliche Haftschicht laminiert. Für diese Art der Übertragung eignen sich (Meth)acrylesterpolymere und insbesondere Vinylacetatpolymere mit einem Erweichungsbereich von 80 bis 180 °C.

Das thermoplastische Polymere ist in der Haftschicht vorzugsweise in einem Anteil von mehr als 50 Gew.-% enthalten. Es hat im allgemeinen eine Erweichungstemperatur im Bereich von 40 bis 200, insbesondere 60 bis 120 °C. Die Haftschicht kann ferner UV-Absorber, antistatische Zusätze, inerte Füllstoffe, optische Aufheller, Zusätze zur Erhöhung der Klebrigkeit und Weichmacher enthalten. Geeignete Haftschichten sind in der US-A 5 049 476 und den älteren deutschen Patentanmeldungen P 42 04 950.4 und P 42 43 253.7 beschrieben. Die Haftschicht ist allgemein dicker als 1 µm; sie hat zumeist ein Schichtgewicht von 2 bis 30, vorzugsweise von 4 bis 12 g/m².

Das Bildempfangsblatt (E) kann aus jedem geeigneten Material bestehen, das den Bedingungen des Laminierens und Auseinanderziehens widersteht und das einen geeigneten visuellen Kontrast zu dem übertragenen Farbbbild bildet. Normalerweise sollte das Material weiß sein. Kunstoffolien, z.B. pigmentierte Polyesterfolien, kunststoffbeschichtete Papiere, z.B. mit Polyethylen beschichtetes Papier, Holz, Glas, Metall und dgl. können verwendet werden. Das Material kann eine haftvermittelnde Vorbeschichtung tragen. Auch kann ein normales Bedruckpapier eingesetzt werden.

Das Laminieren erfolgt, indem das photopolymerisierbare Material mit seiner Haftschicht auf das Empfangsblatt aufgelegt und mit diesem zusammen durch den Spalt von zwei beheizten Laminierwalzen unter ausreichendem Druck geführt wird. Die Laminiertemperatur liegt gewöhnlich im Bereich von 60 bis 130, bevorzugt 70 bis 110 °C. Die Walzen können die gleiche oder verschiedene Temperatur haben; die Laminiergeschwindigkeit liegt gewöhnlich zwischen 10 und 100, bevorzugt bei 20 bis 60 cm/min.

Die photopolymerisierbare Schicht wird in bekannter Weise durch die transparente Trägerfolie (A) vor oder nach dem Laminieren belichtet. Die Belichtung erfolgt gewöhnlich unter einem positiven Rasterfarbauszug im Vakuumkopierrahmen. Als Lichtquellen werden Quecksilberdampflampen bevorzugt. Lichtabsorptionsfilter können zur Verminderung von Streulicht eingesetzt werden.
Nach dem Laminieren und Belichten wird das Bild durch gleichmäßiges Abziehen der Trägerfolie von dem Empfangsblatt bei Raumtemperatur entwickelt. Besondere Vorrichtungen zum Nieder- oder Festhalten des Empfangsblattes während des Abziehens sind nicht erforderlich, weil nur mäßige Abziehkräfte nötig sind. Der Abziehwinkel sollte mindestens 90 ° betragen. Bei dem Abziehen wird die gesamte ungefärbte photopolymerisierbare Schicht (D) zusammen mit den belichteten Bereichen der farbigen polymerisierbaren Schicht mit der Trägerfolie entfernt und die unbelichteten Bereiche der farbigen polymerisierbaren Schicht verbleiben mit der gesamten Haftschicht auf dem Bildempfangsblatt. Es wird somit ein positives Bild der Vorlage erhalten.

Ein weiteres photopolymerisierbares Material mit einer andersfarbigen polymerisierbaren Schicht wird mittels einer Haftschicht auf das erste Teilfarbenbild laminiert und durch den entsprechenden Farbauszug im Register zum ersten Teilfarbenbild belichtet. Das zweite Teilfarbenbild wird in gleicher Weise durch Abziehen der Trägerfolie entwickelt. In gleicher Weise kann ein drittes und viertes Teilfarbenbild hinzugefügt werden. Gewöhnlich wird ein Vierfarbenbild aus den Grundfarben Cyan (Blaugrün), Magenta (Purpur), Gelb und Schwarz aufgebaut. Wenn es gewünscht wird, kann die Oberfläche des fertigen Bildes eine matte Texturierung erhalten, z.B. indem die glänzende Oberfläche im Kontakt mit einer rauhen Oberfläche, z.B. einer mattierten Folie verprägt wird. Dazu werden das Bild und die mattierte Folie zusammen durch einen Walzenspalt eines Laminiergerätes geführt. Durch Auswahl eines entsprechenden mattierten Materials kann die Oberflächentexturierung bestimmt werden. Zum Abschluß kann das fertige Bild durch Ausbelichten mit einer geeigneten Lichtquelle, ggf. unter Erwärmen gehärtet werden. Eine Schutzschicht, wie sie z.B. in der US-A 4 999 266 beschrieben ist, kann auch auf die Oberfläche des fertigen Bildes laminiert werden.

Die folgenden Beispiele erläutern bevorzugte Ausführungsformen der Erfindung. Die Mengen sind zumeist in Gewichtsteilen (Gt) angegeben. Mengenverhältnisse und Prozente sind, wenn nichts anderes angegeben ist, in Gewichtseinheiten zu verstehen.

### Beispiel 1

Eine Lösung von

| | |
|---|---|
| 18,8 Gt | Polyvinylformal, mittleres Molekulargewicht 110.000, 7 % Vinylalkoholeinheiten, 11 % Vinylacetateinheiten und 82 % Vinylformaleinheiten (^{(R)}Formvar 15/95), |
| 11,3 Gt | Dipentaerythritpentaacrylat und |
| 5,6 Gt | 2-(4-Styryl-phenyl)-4,6-bis-trichlormethyl-s-triazin in |
| 1500 Gt | Tetrahydrofuran und |
| 450 Gt | 1-Methoxy-2-propanol |

wird auf die gemäß US-A 4 391 767 haftvermittelte Seite einer 50 µm dicken biaxial verstreckten und thermofixierten Polyethylenterephthalatfolie aufgebracht. Die andere Seite der Folie war mit einer Antiblockausrüstung versehen. Nach zwei Minuten Trocknen bei 70 °C hat die photopolymerisierbare Schicht ein Gewicht von 0,3 g/m².

Auf vier Proben der mit der photopolymerisierbaren Schicht versehenen Polyesterfolie wird jeweils eine der folgenden Beschichtungslösungen für die Grundfarben Cyan, Gelb, Magenta und Schwarz in der Weise aufgebracht, daß mindestens ein Teil der ungefärbten photopolymerisierbaren Schicht ungelöst bleibt:

| | Cyan Gt | Gelb Gt | Magenta Gt | Schwarz Gt |
|---|---|---|---|---|
| Dipentaerythritpentaacrylat | 3,60 | 3,09 | 3,03 | 3,02 |
| Polyvinylformal mittl.Molekulargewicht 80.000, 24 % Vinylalkoholeinheiten, 26 % Vinylacetateinheiten und 50 % Vinylformaleinheiten (^{(R)}Formvar 12/85) | 2,86 | 2,87 | 3,01 | 2,42 |
| ^{(R)}Hostapermblau B2G (C.l. 74 160) | 1,75 | - | - | - |
| Permanentgelb GR (C.l. 21 100) | - | 1,33 | - | - |
| Permanentcarmin FBB (C.l. 12 485) | - | - | 1,58 | - |
| Ruß (^{(R)}Printex 25) | - | - | - | 2,07 |
| Tetrahydrofuran | 93,00 | 79,95 | 78,28 | 78,05 |
| 1-Methoxy-2-propanol | 63,00 | 54,16 | 53,03 | 52,87 |
| γ-Butyrolacton | 12,62 | 11,77 | 14,10 | 15,12 |

Die Farbpigmente werden als Dispersionen in die Lösungen eingebracht. Dazu werden sie zusammen mit einem Teil des Polyvinylformals in Butyrolacton dispergiert und zu der gewünschten Teilchengröße, d.h. einem mittleren Teilchendurchmesser von 0,1 µm vermahlen. Vor dem Beschichten wird jede Beschichtungslösung gut vermischt. Die Beschichtungen werden 2 Minuten bei 70 °C getrocknet; danach haben die optischen Dichten der einzelnen Schichten die folgenden Werte:

| | |
|---|---|
| Cyan | 1,3 |
| Gelb | 1,0 |
| Magenta | 1,4 |
| Schwarz | 1,6 |

Die Schichtgewichte betragen 0,6 g/m².

Auf die Farbschichten wird jeweils eine Haftschichtlösung der folgenden Zusammensetzung aufgebracht:

| | Gt |
|---|---|
| Ammoniumhydroxid (25 %) | 8,5 |
| Natriumsulfit | 1,4 |
| Polyvinylmethylether (^{(R)}Lutonal M 40) | 1,9 |
| pyrogene Kieselsäure, mittl.Teilchengröße 3 µm | 0,1 |
| Copolymer Vinylacetat/Crotonsäure (95 : 5) | 96,7 |
| Wasser | 520,0 |
| Ethanol | 43,0 |

Nach dem Trocknen haben die Haftschichten jeweils ein Gewicht von 6,5 g/m².

Die Cyanfolie wird bei 105 °C mit ihrer Haftschicht auf ein Empfangsblatt aus Papier laminiert. Das lichtempfindliche Material wird dann unter einem Cyan-Positiv-Farbauszug durch die Trägerfolie mittels einer 5 000 W Kopierlampe 3 Sekunden belichtet. Nach dem Belichten wird die Trägerfolie von dem Empfangsblatt abgezogen, wobei die belichteten Stellen der Farbschicht an der Trägerfolie haften und die unbelichteten Stellen zusammen mit der gesamten Haftschicht auf dem Empfangsblatt verbleiben.

Die gelbe lichtempfindliche Farbfolie wird in gleicher Weise auf das Cyan-Teilfarbenbild laminiert, dann unter dem entsprechenden Gelb-Farbauszug belichtet und durch Abziehen der Trägerfolie zum gelben Teilfarbenbild entwickelt. Diese Verfahrensschritte werden entsprechend mit der Magenta- und der Schwarz-Farbfolie wiederholt. Es wird eine genaue Vierfarben-Reproduktion des Originals erhalten.

Die Punktwiedergabe beträgt mindestens 3 bis 99 % in einem Raster von 60 Linien je cm. Die Gelbfärbung in den Nichtbildstellen, gemessen mit einem Blaufilter, entspricht einer optischen Dichte von 0,01; sie steigt bei einer Nachbelichtung von 30 Sekunden nach dem Abziehen der Trägerfolie auf 0,02 an.

### Beispiele 2 bis 8

Eine Cyanfolie wird wie in Beispiel 1 beschrieben, jedoch mit unterschiedlichen Photoinitiatoren in der lichtempfindlichen Schicht hergestellt. In der folgenden Tabelle sind die Photoinitiatoren, ihre Farbe, ihr Absorptionsmaximum, die optimale Belichtungszeit sowie die Hintergrundverfärbung vor und nach der Nachbelichtung angegeben.

| Beispiel | Initiator | λ max (nm) | Belichtungszeit (s) | Verfärbung vor nach Nachbelichtung | |
|---|---|---|---|---|---|
| 1 | wie Beispiel 1 | 371 | 3 | 0,01 | 0,02 |
| 2 | 2-(4-Ethoxy-naphth-1-yl)-4,6-bis-trichlormethyl-s-triazin | 388 | 5 | 0,01 | 0,02 |
| 3 | 2-(4-Methoxy-styryl)-4,6-bis-trichlormethyl-s-triazin | 379 | 6 | 0,01 | 0,02 |
| 4 | Michlers Keton | 366 | 60 | 0,01 | 0,02 |
| 5 | 2-(3,4-Dimethoxy-phenyl)-4,6-bis-trichlormethyl-s-triazin | 352 | 20 | 0,01 | 0,02 |
| 6 | 2-(3,4,5-Trimethoxyphenyl)-4,6-bis-trichlormethyl-s-triazin | 337 | 70 | 0,01 | 0,02 |
| 7 | 2-Biphenylyl-(4)-4,6-bis-trichlormethyl-s-triazin | 332 | 25 | 0,00 | 0,01 |
| 8 | 4,4'-Bis-[2,4-bis-trichlormethyl-triazinyl-(6)]-diphenyl-ether | 331 | 30 | 0,00 | 0,01 |

### Beispiel 9

In der Cyanfolie gemäß Beispiel 1 wird die Menge des Monomeren in der photopolymerisierbaren Schicht verdoppelt, d.h. auf 22,6 Gt erhöht. Die optimale Belichtungszeit beträgt noch immer 3 s. Die Punktwiedergabe wird auf 2 - 98 % verändert. Die Hintergrundverfärbung des Vierfarbenbildes nach Gelb beträgt 0,02, bei Nachbelichtung 0,04 Dichteeinheiten.

### Beispiel 10

Beispiel 1 wird mit der Abwandlung wiederholt, daß das Monomere in der photopolymerisierbaren Schicht der Cyan-Folie durch die gleiche Menge Trimethylolpropantriacrylat ersetzt wird. Die optimale Belichtungszeit beträgt 5 Sekunden. Die Hintergrundverfärbung des Vierfarbenbildes nach Gelb entspricht 0,02, bei Nachbelichtung 0,03 Dichteeinheiten.

### Beispiel 11

Beispiel 1 wird mit der Abwandlung wiederholt, daß das Bindemittel in der photopolymerisierbaren Schicht durch die gleiche Menge eines Ethylmethacrylatpolymeren (Viskosität in 37,5 %-iger Lösung in Toluol 7 500 mPa.s, Säurezahl 0, Tg 63 °C) ersetzt wird. Die Belichtungszeit beträgt 5 Sekunden. Die Hintergrundverfärbung des Vierfarbenbildes nach Gelb entspricht 0,01, bei Nachbelichtung 0,02 Dichteeinheiten. Die Punktwiedergabe beträgt 4 - 97 %.

### Vergleichsbeispiel A

Es wird ähnlich wie in Beispiel 1 gearbeitet, jedoch werden jeweils die photopolymerisierbare Schicht und die Farbschicht zu einer Schicht vereinigt. Die Beschichtungslösungen für die 4 Grundfolien haben die folgende Zusammensetzung:

| | Cyan Gt | Gelb Gt | Magenta Gt | Schwarz Gt |
|---|---|---|---|---|
| Dipentaerythritpentaacrylat | 3,90 | 3,82 | 3,55 | 3,61 |
| Formvar 12/85 | 3,13 | 3,54 | 3,65 | 2,89 |
| s-Triazinderivat gemäß Beispiel 1 | 0,98 | 0,95 | 0,78 | 0,96 |
| Hostapermblau B2G | 1,90 | - | - | - |
| Permanentgelb GR | - | 1,64 | - | - |
| Permanentcarmin FBB | - | - | 1,85 | - |
| Printex 25 | - | - | - | 2,48 |
| Tetrahydrofuran | 100,00 | 100,00 | 100,00 | 100,00 |
| 1-Methoxy-2-propanol | 68,00 | 68,00 | 68,00 | 68,00 |
| γ-Butyrolacton | 19,00 | 19,00 | 19,00 | 19,00 |

Die photopolymerisierbaren Farbschichten werden in gleicher Weise hergestellt wie in Beispiel 1 beschrieben. Die optischen Dichten und Schichtgewichte sind die gleichen wie dort angegeben. Auf die Farbschichten wird jeweils eine gleiche Haftschicht aufgebracht wie in Beispiel 1.

Die Farbfolien werden ebenso wie in Beispiel 1 beschrieben zu einem Mehrfarbenbild verarbeitet. Die Punktwiedergabe beträgt 2 bis 98 %, die Belichtungszeit beträgt je nach Farbe 3 bis 6 Sekunden. Die gelbe Hintergrundverfärbung beträgt 0,04 Dichteeinheiten, weil der in der Farbschicht enthaltene Photoinitiator gelb gefärbt ist. Bei 30 Sekunden Nachbelichtung erhöht sich dieser Wert auf 0,06 und ist damit nicht mehr tolerierbar.

### Vergleichsbeispiel B

Vergleichsbeispiel A wird wiederholt mit der Maßgabe, daß das als Photoinitiator eingesetzte s-Triazin durch die gleiche Menge der weißen Verbindung 2-Biphenylyl-(4)-4,6-bis-trichlormethyl-s-triazin ersetzt wird. Die Punktwiedergabe erstreckt sich von 2 bis 98 %, es sind jedoch Belichtungszeiten von 14 bis 28 Sekunden erforderlich. Die gelbe Hintergrundverfärbung beträgt 0,03 Einheiten; bei Nachbelichtung erhöht sie sich auf 0,09 Einheiten.

### Beispiel 12

Wie in Beispiel 1 beschrieben, werden 4 lichtempfindliche Farbfolien mit der folgenden Beschichtungslösung hergestellt:

| | Cyan Gt | Gelb Gt | Magenta Gt | Schwarz Gt |
|---|---|---|---|---|
| Dipentaerythritpentaacrylat | 3,60 | 3,09 | 3,03 | 3,02 |
| Formvar 12/85 | 2,86 | 2,87 | 3,01 | 2,42 |
| Hostapermblau B2G | 1,75 | - | - | - |
| Permanentgelb GR | - | 1,33 | - | - |
| Permanentcarmin FBB | - | - | 1,58 | - |
| Printex 25 | - | - | - | 2,07 |
| Butanon | 39,00 | 33,53 | 32,83 | 32,73 |
| 1-Methoxy-2-propanol | 87,75 | 75,44 | 73,86 | 73,64 |
| 4-Hydroxy-4-methyl-2-pentanon | 29,25 | 25,15 | 24,62 | 24,54 |
| γ-Butyrolacton | 12,62 | 11,77 | 14,10 | 15,12 |

Die Verarbeitung der Farbfolien erfolgt wie in Beispiel 1 und ergibt im wesentlichen die gleichen Ergebnisse. Das in diesem Beispiel eingesetzte Lösemittelgemisch wird bevorzugt, weil das darin enthaltene 4-Hydroxy-4-methyl-2-pentanon das in der photopolymerisierbaren Unterschicht als Bindemittel enthaltene Polyvinylformal nicht löst. Da das 1-Methoxy-2-propanol keines der verwendeten Polyvinylformale löst, braucht weniger Sorgfalt darauf verwendet zu werden, daß die Unterschicht nicht gelöst wird.

## Patentansprüche

1. Photopolymerisierbares Material mit
(A) einer flexiblen transparenten Trägerfolie,
(B) einer farbigen polymerisierbaren Schicht, die ein organisches Bindemittel, eine radikalisch polymerisierbare Verbindung mit mindestens einer endständigen ethylenisch ungesättigten Gruppe und einen Farbstoff oder ein Farbpigment enthält, und
(C) einer Haftschicht, die ein thermoplastisches Polymeres enthält und ein Tg von 25 bis 100 °C aufweist,
dadurch gekennzeichnet, daß die Schicht (B) keinen Photoinitiator enthält, daß zwischen der Trägerfolie (A) und der farbigen polymerisierbaren Schicht (B) eine ungefärbte photopolymerisierbare Schicht (D) angeordnet ist, die ein polymeres organisches Bindemittel, eine radikalisch polymerisierbare Verbindung mit mindestens einer endständigen ethylenisch ungesättigten Gruppe und einen Photopolymerisationsinitiator enthält, und daß die Kohäsion der Schichten (B), (C) und (D) und die Haftung dieser Schichten untereinander und an der Trägerfolie (A) so eingestellt sind, daß die Haftung (a₂) der photopolymerisierbaren Schicht (D) an der farbigen Schicht (B) im unbelichteten Zustand kleiner ist als die Haftung (a₃) der farbigen Schicht (B) an der Haftschicht (C) und die Haftung (a₁) der photopolymerisierbaren Schicht (D) an der Trägerfolie (A) und als die Kohäsionen (c₁), (c₂) und (c₃) der Schichten (D), (B) und (C) und daß die Haftung (a₃') der farbigen Schicht (B) an der Haftschicht (C) im belichteten Zustand kleiner ist als die Haftung (a₁') der photopolymerisierten Schicht (D) an der Trägerfolie (A) und die Haftung (a₂') der photopolymerisierten Schicht (D) an der farbigen Schicht (B) und als die Kohäsionen (c₁'), (c₂') und (c₃') der Schichten (D), (B) und (C).

2. Photopolymerisierbares Material nach Anspruch 1 dadurch gekennzeichnet, daß die farbige polymerisierbare Schicht (B) nicht lichtempfindlich ist.

3. Photopolymerisierbares Material nach Anspruch 1, dadurch gekennzeichnet, daß die Oberfläche der Trägerfolie (A), auf der sich die ungefärbte Schicht (D) befindet, zur Erhöhung ihrer Haftung vorbehandelt worden ist.

4. Photopolymerisierbares Material nach Anspruch 3, dadurch gekennzeichnet, daß die Oberfläche durch Beschichten mit einem Acryl- oder Methacrylsäureesterpolymeren vorbehandelt worden ist.

5. Photopolymerisierbares Material nach Anspruch 1, dadurch gekennzeichnet, daß die radikalisch polymerisierbare Verbindung mindestens zwei endständige ethylenisch ungesättigte Gruppen aufweist.

6. Photopolymerisierbares Material nach Anspruch 1, dadurch gekennzeichnet, daß die ungefärbte photopolymerisierbare Schicht (D) ein Gewicht von 0,05 bis 3 g/m² hat.

7. Photopolymerisierbares Material nach Anspruch 1, dadurch gekennzeichnet, daß die farbige polymerisierbare Schicht (B) ein Gewicht von 0,1 bis 5 g/m² hat.

8. Photopolymerisierbares Material nach Anspruch 1, dadurch gekennzeichnet, daß die Haftschicht (C) ein Gewicht von 2 bis 30 g/m² hat.

9. Photopolymerisierbares Material nach Anspruch 1, dadurch gekennzeichnet, daß die farbige polymerisierbare Schicht (B) dicker ist als die ungefärbte photopolymerisierbare Schicht (D).

10. Verfahren zur Herstellung eines farbigen Bildes, dadurch gekennzeichnet, daß man ein photopolymerisierbares Material gemäß Anspruch 1 mit seiner Haftschicht (C) unter Druck und bei erhöhter Temperatur auf ein Bildempfangsblatt (E) laminiert, das erhaltene Laminat durch die Trägerfolie (A) hindurch bildmäßig belichtet und die Trägerfolie zusammen mit der photopolymerisierbaren Schicht (D) und den belichteten Bereichen der farbigen polymerisierbaren Schicht (B) von dem Empfangsblatt abzieht, wobei die Haftung der Haftschicht (C) an dem Bildempfangsblatt (E) im unbelichteten Zustand (a₄) größer ist als die Haftung (a₂) der photopolymerisierbaren Schicht (D) an der farbigen Schicht (B) und im belichteten Zustand (a₄') größer ist als die Haftung (a₃') der farbigen polymerisierbaren Schicht (B) an der Haftschicht (C).

11. Verfahren nach Anspruch 10, dadurch gekennzeichnet, daß man ein Teilfarbenbild herstellt, indem man ein photopolymerisierbares Material einsetzt, dessen farbige polymerisierbare Schicht (B) in einer Grundfarbe des Mehrfarbendruckes gefärbt ist, und die Belichtung unter einem Farbauszug für die gleiche Grundfarbe vornimmt.

12. Verfahren nach Anspruch 10, dadurch gekennzeichnet, daß man ein photopolymerisierbares Material einer anderen Grundfarbe auf das erste Teilfarbenbild laminiert und die Belichtung im Register zu dem ersten Teilfarbenbild vornimmt und die gleichen Schritte ggf. mit mindestens einer weiteren Grundfarbe wiederholt.

13. Verfahren nach Anspruch 10, dadurch gekennzeichnet, daß man das photopolymerisierbare Material bei einer Temperatur im Bereich von 60 bis 130 °C auf das Empfangsblatt laminiert.

14. Verfahren nach Anspruch 10, dadurch gekennzeichnet, daß man das farbige Bild auf dem Bildempfangsmaterial mit einem Schutzüberzug abdeckt.

15. Verfahren nach Anspruch 10, dadurch gekennzeichnet, daß man das auf dem Bildempfangsblatt nach dem Abziehen der Trägerfolie erhaltene farbige Bild durch Belichten ohne Vorlage aushärtet.

## Claims

1. A photopolymerisable material having
(A) a flexible transparent base film,
(B) a coloured polymerisable layer which contains an organic binder, a compound which is polymerisable by a radical mechanism and which contains at least one ethylenically unsaturated terminal group, and a dye or a coloured pigment, and
(C) an adhesion layer which contains a thermoplastic polymer and has a Tg of 25 to 100°C,
characterised in that layer (B) does not contain a photoinitiator, that an uncoloured photopolymerisable layer (D) is disposed between the base film (A) and the coloured polymerisable layer (B) and contains a polymeric organic binder, a compound which is polymerisable by a radical mechanism and which contains at least one ethylenically unsaturated terminal group, and a photopolymerisation initiator, and that the cohesion of layers (B), (C) and (D) and the adhesion of these layers to each other and to the base film (A) is adjusted so that the adhesion (a₂) of the photopolymerisable layer (D) to the coloured layer (B) in the unexposed state is less than the adhesion (a₃) of the coloured layer (B) to the adhesion layer (C) and less than the adhesion (a₁) of the photopolymerisable layer (D) to the base film (A), and is less than the cohesions (c₁), (c₂) and (c₃) of layers (D), (B) and (C), and that the adhesion (a₃') of the coloured layer (B) to the adhesion layer (C) in the exposed state is less than the adhesion (a₁') of the photopolymerised layer (D) to the base film (A) and less than the adhesion (a₂') of the photopolymerised layer (D) to the coloured layer (B) and is less than the cohesions (c₁'), (c₂') and (c₃') of layers (D), (B) and (C).

2. A photopolymerisable material according to claim 1, characterised in that the coloured polymerisable layer (B) is not light-sensitive.

3. A photopolymerisable material according to claim 1, characterised in that the surface of the base film (A) on which the uncoloured layer (D) is situated has been pretreated to increase its adhesion.

4. A photopolymerisable material according to claim 3, characterised in that the surface has been pretreated by coating with an acrylic acid or methacrylic acid ester polymer.

5. A photopolymerisable material according to claim 1, characterised in that the compound which is polymerisable by a radical mechanism contains at least two ethylenically unsaturated terminal groups.

6. A photopolymerisable material according to claim 1, characterised in that the uncoloured photopolymerisable layer (D) has a weight of 0.05 to 3 g/m².

7. A photopolymerisable material according to claim 1, characterised in that the coloured polymerisable layer (B) has a weight of 0.1 to 5 g/m².

8. A photopolymerisable material according to claim 1, characterised in that the adhesion layer (C) has a weight of 2 to 30 g/m².

9. A photopolymerisable material according to claim 1, characterised in that the coloured polymerisable layer (B) is thicker than the uncoloured photopolymerisable layer (D).

10. A method of producing a coloured image, characterised in that a photopolymerisable material according to claim 1 is laminated, under pressure and at elevated temperature, on to an image-receiving sheet (E) with its adhesion layer (C), the laminate obtained is exposed image-wise through the base film (A), and the base film together with the photopolymerisable layer (D) and the exposed regions of the coloured polymerisable layer (B) is peeled off from the receiving sheet, wherein the adhesion of the adhesion layer (C) to the image-receiving sheet (E) in the unexposed state (a₄) is greater than the adhesion (a₂) of the photopolymerisable layer (D) to the coloured layer (B), and in the exposed state (a₄') is greater than the adhesion (a₃') of the coloured polymerisable layer (B) to the adhesion layer (C).

11. A method according to claim 10, characterised in that a partial colour image is produced by using a photopolymerisable material, the coloured polymerisable layer (B) of which is coloured in a primary colour of the multicolour print, and effecting the exposure with a colour separation for the same primary colour.

12. A method according to claim 10, characterised in that a photopolymerisable material of another primary colour is laminated on to the first partial colour image and the exposure is effected in register with the first partial colour image and the same steps are optionally repeated with at least one further primary colour.

13. A method according to claim 10, characterised in that the photopolymerisable material is laminated on to the receiving sheet at a temperature within the range from 60 to 130°C.

14. A method according to claim 10, characterised in that the coloured image on the image receiving material is covered with a protective coating.

15. A method according to claim 10, characterised in that the coloured image obtained on the image receiving sheet after peeling off the base film is hardened by exposure without a pattern.

## Revendications

1. Matériau photopolymérisable avec
(A) une feuille support transparente flexible,
(B) une couche polymérisable colorée qui contient un liant organique, un composé polymérisable par voie radicalaire ayant au moins un groupe éthyléniquement insaturé terminal et un colorant ou un pigment colorant, et
(C) une couche d'adhésion qui contient un polymère thermoplastique et qui présente une Tg de 25 à 100°C,
caractérisé en ce que la couche (B) ne contient pas de photoinitiateur, en ce qu'entre la feuille support (A) et la couche polymérisable colorée (B) est disposée une couche photopolymérisable non colorée (D) qui contient un liant organique polymérique, un composé polymérisable par voie radicalaire ayant au moins un groupe éthyléniquement insaturé terminal et un amorceur de photopolymérisation, et en ce que la cohésion des couches (B), (C) et (D) et l'adhésion de ces couches entre elles et à la feuille support (A) sont ajustées de telle manière que l'adhésion (a₂) de la couche photopolymérisable (D) à la couche colorée (B) à l'état non éclairé est inférieure à l'adhésion (a₃) de la couche colorée (B) à la couche d'adhésion (C) et à l'adhésion (a₁) de la couche photopolymérisable (D) à la feuille support (A) et aux cohésions (c₁), c₂) et (c₃) des couches (D), (B) et (C) et en ce que l'adhésion (a'₃) de la couche colorée (B) à la couche d'adhésion (C) à l'état éclairé est inférieure à l'adhésion (a'₁) de la couche photopolymérisée (D) à la feuille support (A) et à l'adhésion (a'₂) de la couche photopolymérisée (D) à la couche colorée (B) et aux cohésions (c'₁), (c'₂) et (c'₃) des couches (D), (B) et (C).

2. Matériau photopolymérisable selon la revendication 1, caractérisé en ce que la couche polymérisable colorée (B) n'est pas sensible à la lumière.

3. Matériau photopolymérisable selon la revendication 1, caractérisé en ce que la surface de la feuille support (A) sur laquelle se trouve la couche non colorée (D) a été prétraitée pour augmenter son adhésion.

4. Matériau photopolymérisable selon la revendication 3, caractérisé en ce'que la surface a été prétraitée par revêtement avec un polymère d'ester d'acide acrylique ou méthacrylique.

5. Matériau photopolymérisable selon la revendication 1, caractérisé en ce que le composé polymérisable par voie radicalaire comporte au moins deux groupes éthyléniquement insaturés terminaux.

6. Matériau photopolymérisable selon la revendication 1, caractérisé en ce que la couche photopolymérisable non colorée (D) a un poids de 0,05 à 3 g/m².

7. Matériau photopolymérisable selon la revendication 1, caractérisé en ce que la couche polymérisable colorée (B) a un poids de 0,1 à 5 g/m².

8. Matériau photopolymérisable selon la revendication 1, caractérisé en ce que la couche d'adhésion (C) a un poids de 2 à 30 g/m².

9. Matériau photopolymérisable selon la revendication 1, caractérisé en ce que la couche polymérisable colorée (B) est plus épaisse que la couche photopolymérisable non colorée (D).

10. Procédé de production d'une image colorée, caractérisé en ce que l'on stratifie un matériau photopolymérisable selon la revendication 1 avec sa couche d'adhésion (C) sous pression et à température élevée sur une feuille de réception d'image (E), on éclaire selon une image le stratifié obtenu au travers de la feuille support (A) et on retire de la feuille de réception la feuille support en même temps que la couche photopolymérisable (D) et les domaines éclairés de la couche polymérisable colorée (B), l'adhésion de la couche d'adhésion (C) à la feuille de réception d'image (E) à l'état non éclairé (a₄) étant supérieure à l'adhésion (a₂) de la couche photopolymérisable (D) à la couche colorée (B) et, à l'état éclairé (a'₄), supérieure à l'adhésion (a'₃) de la couche polymérisable colorée (B) à la couche d'adhésion (C).

11. Procédé selon la revendication 10, caractérisé en ce que l'on produit une image monochrome en utilisant un matériau photopolymérisable dont la couche polymérisable colorée (B) est colorée en une couleur primaire de l'impression en plusieurs couleurs et on réalise l'éclairement sous un séparateur de couleur pour la même couleur primaire.

12. Procédé selon la revendication 10, caractérisé en ce que l'on stratifie un matériau photopolymérisable d'une autre couleur primaire sur l'image monochrome et on réalise l'éclairement en registre avec la première image monochrome et on répète les mêmes étapes éventuellement avec au moins une autre couleur primaire.

13. Procédé selon la revendication 10, caractérisé en ce que l'on stratifie le matériau photopolymérisable à une température dans le domaine de 60 à 130°C sur la feuille de réception.

14. Procédé selon la revendication 10, caractérisé en ce que l'on recouvre d'un revêtement protecteur l'image colorée sur le matériau de réception d'image.

15. Procédé selon la revendication 10, caractérisé en ce que l'on durcit par éclairement sans original l'image colorée obtenue sur la feuille de réception d'image après retrait de la feuille support.
